# EUROPÄISCHE PATENTSCHRIFT

(11) **EP 1 206 840 B1**
(45) Veröffentlichungstag und Bekanntmachung des Hinweises auf die Patenterteilung: **13.08.2003**
(21) Anmeldenummer: 00915115.0
(22) Anmeldetag: 24.02.2000
(51) Int. Cl.: H03M 1/46

(54) **VERFAHREN UND VORRICHTUNG ZUR CODIERUNG/DECODIERUNG**
METHOD AND DEVICE FOR CODING/DECODING
PROCEDE ET DISPOSITIF POUR CODER/DECODER

(30) Priorität: 31.03.1999 DE 19914645
(43) Veröffentlichungstag der Anmeldung: 22.05.2002
(73) Patentinhaber: ROBERT BOSCH GMBH, 70442 Stuttgart (DE)
(72) Erfinder: MEINE, Nikolaus, D-30473 Hannover (DE); PURNHAGEN, Heiko, D-30163 Hannover (DE)
(86) Internationale Anmeldenummer: DE0000510
(87) Internationale Veröffentlichungsnummer: WO00060744

(56) Entgegenhaltungen:
- LAMPINEN H ET AL: "A NEW DUAL-MODE DATA COMPRESSING A/D CONVERTER" IEEE INTERNATIONAL SYMPOSIUM ON CIRCUITS AND SYSTEMS,US,NEW-YORK, NY: IEEE, 9. Juni 1997 (1997-06-09), Seiten 429-432, XP000805428 ISBN: 0-7803-3584-8
- DINESH K ANVEKAR ET AL: "A PROGRAMMABLE NONLINEAR ADC USING OPTIMAL-SIZED ROM" IEEE TRANSACTIONS ON INSTRUMENTATION AND MEASUREMENT,US,IEEE INC. NEW YORK, Bd. 40, Nr. 6, 1. Dezember 1991 (1991-12-01), Seiten 1031-1035, XP000299427 ISSN: 0018-9456
- PATENT ABSTRACTS OF JAPAN vol. 009, no. 258 (E-350), 16. Oktober 1985 (1985-10-16) & JP 60 106228 A (NIPPON DENKI KK), 11. Juni 1985 (1985-06-11)

## Beschreibung

### Stand der Technik

Die Erfindung geht aus von einem Verfahren und einer Vorrichtung zur Codierung/Decodierung unter Verwendung von sich wiederholenden Rekursionsschritten. Bei jedem dieser Rekursionsschritte wird dabei ein Intervall, in dem sich ein zu codierender Wert befindet, in zwei neue Intervalle aufgeteilt und es wird durch ein Bit angezeigt, in welchem der so gebildeten neuen Intervalle sich der Wert befindet. Das Verfahren wird so lange fortgeführt bis der zu codierende/decodierende Wert eingegrenzt ist.

Ein Verfahren und eine Vorrichtung dieser Art sind zum Beispiel beschrieben in dem Artikel von H. Lampinen et al: 'A new dual-mode data compressing a/d converter', IEEE International Symposium on Circuits and Systems, US, New-York, NY, IEEE, 9. Juni 1997, Seiten 429-432.

### Vorteile der Erfindung

Das erfindungsgemäße Verfahren beziehungsweise die erfindungsgemäße Vorrichtung mit den Merkmalen der unabhängigen Patentansprüche hat den Vorteil, daß die Anzahl der Codebits gering gehalten wird.

Weitere Vorteile ergeben sich aus den Maßnahmen der abhängigen Patentansprüche. Besonders vorteilhaft ist das Verfahren bei der Codierung/Decodierung einer Vielzahl von Daten die eine bestimmte Reihenfolge aufweisen. Bei richtiger Wahl der Intervallgrenze können dabei große Einsparungen hinsichtlich der Anzahl der benötigten Codebits erzielt werden. Als besonders einfaches Modell werden Wahrscheinlichkeitsverteilungen verwendet, die davon abhängen, wieviele Elemente in der Reihenfolge nachfolgen. Für bestimmte Anwendungen hat sich auch die Verwendung von gemessenen Wahrscheinlichkeitsverteilungen bewährt. Dies gilt insbesondere für Audiodaten. Gemessene Wahrscheinlichkeitsverteilungen lasen sich besonders einfach abspeichern, wenn sie zu Intervalltabellen umgesetzt werden.

Auch im eingangs erwähnten Artikel wird die Anzahl der Codebits gering gehalten, dort aber durch Komprimierung nach einer Art Gleitkommaverfahren damit während einigen der ersten Rekursionsschritten die neue Intervalle in nichtlinearer Weise gewählt werden, anfangend mit einem Grenzwert von V_{ref}/16 statt V_{ref}/2.

### Zeichnungen

Ausführungsbeispiele der Erfindungen sind in den Zeichnungen dargestellt und in der nachfolgenden Beschreibung näher erläutert. Es zeigen die
Figur 1 einen Sender und einen Empfänger
Figur 2 die Auswahl eines Wertes durch Intervallschachtelung, und die
Figuren 3 bis 5 unterschiedliche Wahrscheinlichkeitsverteilungen.

### Beschreibung

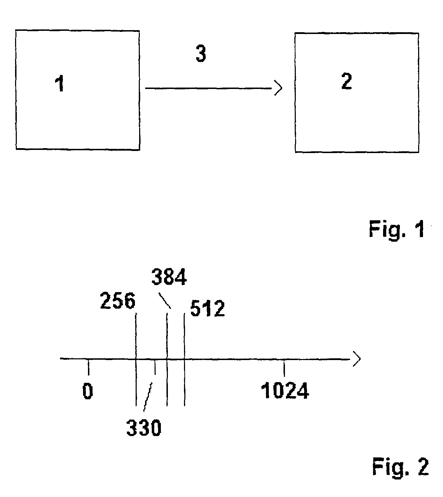

In der Figur 1 wird ein System zur Übermittlung von Daten gezeigt, mit einer Sendestation 1 und einer Empfangsstation 2 wobei die Sendestation 1 über einen Übertragungskanal 3 Daten an die Empfangsstation 2 sendet. Zum Zweck der Übertragung ist es notwendig, die zu übertragenden Daten zu codieren, daß heißt in der Sendestation 1 werden die zu sendenden Daten in digitale Bitsignale umgesetzt, die dann über die Übertragungsstrecke 3 übertragen werden. In der Empfangsstation 2 werden die so übertragenden Bitfolgen decodiert, das heißt aus den empfangenen Bitfolgen werden die ursprünglichen Signale wieder hergestellt. Das folgende Verfahren beschäftigt sich damit, wie die Codierung bestimmter Daten besonders effektiv vorgenommen wird, das heißt wie mit besonders wenigen Codierungsbit möglichst große Datenmengen übertragen werden.

Die zu codierenden Daten werden in der Figur 2 anhand des Zahlenstrahls der einen Wertebereich von 0 bis 1023 (=2¹⁰-1) darstellt, erläutert. Die zu codierenden Informationen oder Daten bestehen darin, daß aus dem in der Figur 2 gezeigten Wertebereich von 0 bis 1023 einzelne Zahlen ausgewählt werden. In der Figur 2 wird dies anhand der Zahl 330 erläutert. Die Information, das heißt das einzelne Datum was hier von der Sendestation 1 zur Empfangsstation 2 übertragen werden soll besteht somit in der Auswahl der Zahl 330 aus der Menge der Zahlen von 0 bis 1023.

In der Figur 2 wird dazu erläutert, wie durch eine Intervallschachtelung der Wert 330 eingegrenzt wird. In einem ersten Schritt, der im folgenden als Rekursionsschritt bezeichnet wird, erfolgt eine Aufteilung des maximal möglichen Intervalls (im ersten Schritt = Intervall 0 - 1023) in zwei neue Teilintervalle. Als Startintervall wird dabei der gesamte Wertebereich, das heißt die Zahlen zwischen 0 und 1023 durch Festlegung der Intervallgrenze 512 in zwei Teilintervalle unterteilt, wobei das erste Intervall von 0 bis 511 und das zweite Teilintervall von 512 bis 1.023 reicht. Durch ein einzelnes Bit wird dann angezeigt, in welchem Intervall sich die hier zu codierende Zahl 330 befindet, beispielsweise kann durch eine 0 immer angezeigt werden, daß sich die zu codierende Zahl im unteren Intervall befindet und durch eine 1, daß sich die zu codierende Zahl im oberen Teilintervall befindet. Im vorliegenden Beispiel wäre somit das erste Codebit 0, da sich die zu codierende Zahl 330 im unteren Intervall, daß heißt in dem Intervall von 0 bis 511 befindet. In einem zweiten Schritt wird das vorgefundene Intervall erneut in Teilintervalle aufgeteilt. Dies erfolgt anhand der Intervallgrenze 256 und es wird durch ein einzelnes Bit signalisiert ob sich die zu codierende Zahl 330 im unteren Intervall, daß heißt zwischen 0 und 255, oder im oberen Intervall, daß heißt zwischen 256 und 511 befindet. Im vorliegenden Fall ist das Codebit 1, da die zu codierende Zahl 330 im oberen Intervall ist. Dieses Intervall wird nun in einem weiteren Schritt wiederum in zwei neue Intervalle aufgeteilt, wobei das untere Intervall von 256 bis 384 und das obere Intervall von 384 bis 512 reicht. Das Codebit 0 zeigt dann an, daß sich die zu codierende Zahl 330 im unteren Intervall befindet. Dieses Verfahren wird so lange fortgesetzt bis die verbliebene Intervallbreite gerade eine Zahl umfaßt, daß heißt die Zahl 330.

Die Decodierung erfolgt in gleicher Weise, in dem die empfangende Station 2 anhand der empfangenen Bitfolgen ebenfalls eine Intervallschachtelung durchführt, bis die so codierte Zahl 330 auf dem Intervall von 0 bis 1023 aufgefunden wurde.

Wie sich leicht feststellen läßt, werden bei dieser Methode, die auf einer Halbierung des jeweils betrachteten Intervalls in zwei neue gleichgroße Intervalle besteht, zur Auswahl oder Codierung einer Zahl aus dem Intervall von 0 bis 1023 immer 10 Bit benötigt. Gegenüber einer unmittelbaren Verwendung des Dualsystems zur Übertragung der Zahl werden somit keinerlei Bits eingespart. Dies ändert sich jedoch, wenn als Intervallgrenzen nicht wie hier immer eine Halbierung des Intervalls erfolgt, sondern wenn aufgrund einer Wahrscheinlichkeitsverteiltung andere Intervallgrenzen für die Intervallschachtelung gewählt werden. Wenn beispielsweise die zu codierenden Zahlen eine größere Wahrscheinlichkeit haben nahe bei dem Wert 0 zu liegen als bei dem Wert 1023, so kann durch geschickte Wahl der Intervallgrenzen bei der Intervallschachtelung die Anzahl der benötigten Bits verringert werden. Wenn beispielsweise die übertragenden Zahlen mit einer Wahrscheinlichkeit von 0,5 in dem Intervall von 0 bis 63 liegen und mit der verbleibenden Wahrscheinlichkeit von 0,5 in dem Intervall von 64 bis 1023 so kann im statistischen Mittel der Codierungsbedarf verringert werden indem für die erste Intervallschachtelung der untere Intervallbereich von 0 bis 63 und der obere Intervallbereich von 64 bis 1024 reicht. Wenn dann das erste Codierbit eine 0 ist, so ist klar, daß sich der zu codierende Wert im Intervall von 0 bis 63 befindet und es kann mit 6 weiteren Bits der zu übertragende Wert codiert werden. Unter Ausnutzung einer Wahrscheinlichkeitsverteilung für die zu codierenden oder decodierenden Werte bei der Intervallschachtelung kann somit der Aufwand an Bits für die Codierung verringert werden.

Ein weiterer Vorteil ergibt sich bei der Übertragung einer Menge von mehrere Zahlen. Wenn mehrere Zahlen aus dem Intervall 0 bis 1023 übertragen, das heißt codiert und dann entsprechend wieder decodiert werden sollen, so kann durch die Sortierung der Daten die Zahl der benötigten Codebits verringert werden. Wesentlich ist dabei, daß die Zahlen in der Reihenfolge übertragen, das heißt auch codiert und decodiert werden, in der sie eine absteigende oder aufsteigende Reihe bilden. Wenn nämlich nach der Codierung der Zahl 330 klar ist, das die nachfolgende Zahl größer oder kleiner ist, so kann das für die Intervallschachtelung benötigte Intervall verringert werden. Im folgenden sei zugrunde gelegt, daß zusätzlich noch die Zahl 450 übertragen werden soll und daß sowohl der Sender 1 (der Coder) und der Empfänger 2 (der Decoder) wissen, daß zwei Zahlen übertragen werden, und das die erste übertragene Zahl die kleinere ist. Sowohl bei der Codierung als auch bei der Decodierung braucht dann nur noch das Intervall von 330 bis 1023 betrachtet werden. Da dieses Intervall kleiner ist als das Intervall von 0 bis 1023 können eventuell weniger Bits verwendet werden. Die Zahl der für die Codierung benötigten Bits kann somit verringert werden wenn bei einer Mehrzahl von zu übertragenden (zu codierenden/decodierenden) Zahlen diese in einer Reihenfolge übertragen werden und dem Sender und dem Empfänger dieses bekannt ist. Wenn beispielsweise die kleinere Zahl 960 beträgt, so verbleiben im Restintervall nur noch 64 Zahlen, die sich ja einfach mit 6 Bits codieren lassen. Es können somit Bits dadurch eingespart werden, daß mehrere Zahlen in einer bestimmten Reihenfolge übertragen werden. Weiterhin hat sich gezeigt, daß unter dieser Voraussetzung die Intervallgrenzen für die Intervallschachtelungen nicht jeweils durch eine Halbierung des verbliebenen Restintervalls bestehen sollten.

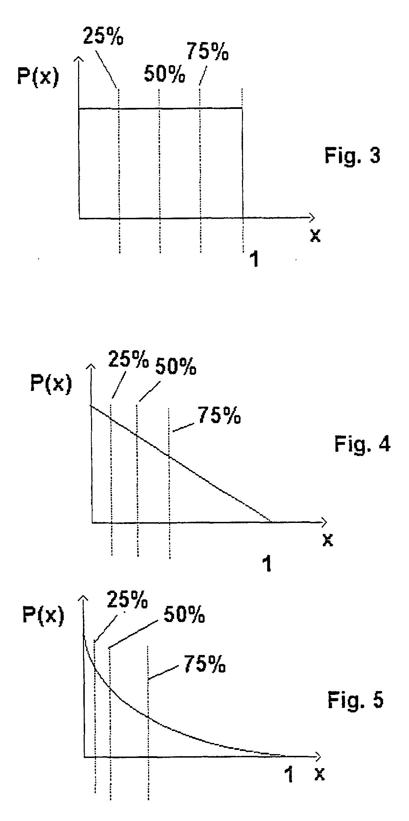

In den Figuren 3, 4 und 5 werden verschiedene Wahrscheinlichkeitsverteilungen erläutert, die sich aus theoretischen Betrachtungen ergeben. Es hat sich in der Praxis herausgestellt, daß diese Wahrscheinlichkeitsverteilungen für reale Daten insbesondere für real zu codierende Audiodaten recht gute Näherungen darstellen.

In den Figuren 3, 4 und 5 wird die Wahrscheinlichkeitsverteilung P(x) gegenüber einem Normintervall von x, welches von 0 bis 1 reicht, gezeigt. Für eine konkrete Anwendung muß dieses Normintervall jeweils auf den konkreten Zahlenbereich umgerechnet werden, in dem die zu codierenden/decodierenden Zahlen liegen. Den Figuren 3 bis 5 liegt die Erkenntnis zugrunde, daß die Verteilung der Zahlen in einem Intervall davon abhängt, wieviel Zahlen insgesamt in dem Intervall vorhanden sind. Dies ist insbesondere von Bedeutung wenn eine Mehrzahl von Zahlen codiert/decodiert werden. Wenn aus einem Wertebereich beispielsweise 10 Zahlen codiert/decodiert werden sollen, so ist eine andere Wahrscheinlichkeitsfunktion zugrunde zu legen als wenn nur eine einzige Zahl codiert/decodiert werden soll. Für die sukzessive Codierung/Decodierung von Zahlen bedeutet dies, daß für jeden Codierungs/Decodierungsschritt eine andere Wahrscheinlichkeitsverteilung verwendet werden muß. Dazu muß bei der Codierung und bei der Decodierung bekannt sein, wie groß die Gesamtzahl der zu codierenden oder zu decodierenden Zahlen ist. Es ergeben sich dann die in den Figuren 3 bis 5 gezeigten Wahrscheinlichkeitsverteilungen unter der Voraussetzung, daß eine Gleichverteilung der Zahlen auf dem gesamten möglichen Wertebereich unterstellt wird.

In der Figur 3 wird die Wahrscheinlichkeitsverteilung P(x) gezeigt wie sie sich darstellt, wenn nur ein einziger Wert codiert/decodiert wird. Wie leicht zu erkennen ist, ist die Wahrscheinlichkeitsverteilung über dem gesamten normierten Wertebereich von 0 bis 1 konstant. In diesem Fall werden die zweckmäßigen Intervallgrenzen jeweils durch eine Teilung in der Mitte erreicht. In der Figur 3 werden die sinnvollen Intervallgrenzen durch senkrechte Striche, die jeweils mit Prozentzahlen versehen sind, gezeigt. Die 50%-Linie ist bei x=0,25, die 50%-Linie bei x=0,5 und die 75%-Linie bei x=0,75. Wie leicht nachzuvollziehen ist, wird durch die 50% Grenze ein unteres und ein oberes Intervall geschaffen, wobei die Wahrscheinlichkeit, daß der zu codierende/decodierende Wert im unteren Intervall liegt 50% beträgt und entsprechend die Wahrscheinlichkeit daß er im oberen Intervall liegt, ebenfalls 50% beträgt. Wenn im ersten Teilungsschritt dann festgestellt wird, daß der zu codierende/decodierende Wert im unteren Intervall liegt so stellt die 25% Grenze durch die ja dieses neue Intervall ebenfalls in zwei Intervalle mit jeweils 50% Wahrscheinlichkeit unterteilt wird, die nächste günstige Teilungsgrenze dar. Aus der Figur 3 ergibt sich auch, daß unter der Annahme der Gleichverteilung für die Codierung/Decodierung eines einzelnen Werts aus einem Intervall kaum Bits ersparen lassen, da dies ja gerade dem Teilungsverfahren entspricht wie es in der Figur 2 erläutert wurde.

In der Figur 4 wird die Wahrscheinlichkeitsverteilung für eine Zahl auf dem Normintervall von 0 bis 1 gezeigt, unter der Voraussetzung, daß noch eine weitere Zahl zu codieren/decodieren ist und eine gleiche, unabhängige Wahrscheinlichkeit beider Zahlen über dem gesamten Werteintervall unterstellt wird. Dabei werden die zu codierenden Zahlen in einer bestimmten Reihenfolge beispielsweise die kleinere Zahl zuerst und danach die größere Zahl codiert. Für die Codierung der ersten Zahl ist dann die Wahrscheinlichkeit nicht über dem gesamten Wertebereich von 0 bis 1023 gleich groß. Wenn die kleinere Zahl den Wert 1022 annimmt so muß die größere Zahl den Wert 1023 annehmen, was aber nichts anderes bedeutet, als das die Wahrscheinlichkeit für die kleinere Zahl den Wert 1022 anzunehmen relativ gering ist. Umgekehrt ist es so, daß, wenn die kleinere Zahl den Wert 1 hat, dann für die zweite, das heißt die größere Zahl, der Wertebereich von 1 bis 1023 zur Verfügung steht, daß heißt die Wahrscheinlichkeit für die kleinere Zahl den Wert 1 anzunehmen ist wesentlich größer als die Wahrscheinlichkeit, daß die kleinere Zahl den Wert 1022 hat. Entsprechend ergibt sich der Wahrscheinlichkeitsverlauf für die kleinere Zahl, der bei 1 am größten und am Ende des Wertebereich bei 1023 am geringsten ist. In dem normierten Wertebereich von 0 bis 1 bedeutet dies, daß die Wahrscheinlichkeit P(x) bei 0 am größten ist und bei 1 am geringsten ist. Für die Codierung/Decodierung von zwei Zahlen mittels Intervallschachtelung sollte daher für die kleinere Zahl die Wahrscheinlichkeitsverteilung nach der Figur 4 und für die größere Zahl die Wahrscheinlichkeitsverteilung nach der Figur 3 verwendet werden. Die Verteilung nach Figur 4 ist dabei durch eine Multiplikation mit dem Wertebereich auf den gesamten Wertebereich umzurechnen, die Verteilung nach der Figur 3 ist durch Multiplikation und Verschiebung auf das Restintervall, daß sich vom kleineren Wert bis zur Obergrenze des Wertebereichs erstreckt, umzurechnen. Die Intervallgrenzen sollten immmer so gewählt werden, daß die Wahrscheinlichkeit für eine Zahl in den jeweils zwei neuen Intervallen zu liegen gleich groß ist. Für diese Aufteilung sind hier wie bei der Figur 3 die ersten Intervallgrenzen eingezeichnet. Die 25%-Linie ist bei x=0,134, die 50%-Linie bei x=0,293 und die 75%-Linie bei x=0,500. Bei ersten Teilungsschritt wird die 50%-Linie und bei zweiten entweder die 25%-Linie oder die 75%-Linie gewählt, je nachdem in welchen Intervall die zu codierende/decodierende Zahl liegt.

In der Figur 4 wird die Wahrscheinlichkeitsverteilung im Normintervall von 0 bis 1 für eine zu codierende/decodierende Zahl unter der Voraussetzung dargestellt, daß es noch eine weitere Zahl gibt. Weiterhin ist es für die Figur 4 Voraussetzung, daß die Zahlen in einer Reihenfolge codiert/decodiert werden. Unter dieser Voraussetzung können dann für die Festlegung der Intervallgrenzen der Intervallschachtelung die Grenzen gewählt werden, wie sie in der Figur 4 wieder durch die Prozentzahlen angegeben sind. Wesentlich ist dabei, daß diese Intervallgrenzen nicht eine Halbierung des Intervalls bewirken, sondern daß sie unsymmetrisch so ausgelegt sind, daß die Wahrscheinlichkeit für die zu codierende/decodierende Zahl jeweils rechts und links der Intervallgrenzen jeweils 50% beträgt.

In der Figur 5 wird die Wahrscheinlichkeitsverteilung in dem Normintervall von 0 bis 1 für eine Zahl aus diesem Normintervall gezeigt unter der Voraussetzung, daß auf die so codierte/decodierte Zahl noch zwei weitere zu codierende/decodierende Zahlen folgen, deren Werte größer sind als die Zahl für die die Wahrscheinlichkeitsverteilung der Figur 5 gilt. Wie zu erkennen ist, ergibt sich unter diesen Voraussetzungen für diese zu codierende/decodierende Zahl eine Wahrscheinlichkeitsverteilung bei der die kleinen Werte (das heißt die Werte nahe 0) wahrscheinlicher sind als die Werte nahe 1. Basierend auf dieser Wahrscheinlichkeitsverteilung können dann Intervallgrenzen, die hier mit 25%, 50%, 75% eingezeichnet sind gewählt werden, die zu einer sehr effizienten Codierung dieser Zahl führen, die nur wenige Bits benötigt. Die 25%-Linie ist bei x=0,0914, die 50%-Linie bei x=0,206 und die 75%-Linie bei x=0,370.

Entsprechende Wahrscheinlichkeitsverteilungen lassen sich aufstellen unter der Voraussetzunge, daß 4 Werte nachfolgen, 5 Werte nachfolgen u.s.w.. Es hat sich jedoch herausgestellt, daß mit zunehmender Anzahl der Werte sich die Wahrscheinlichkeitsverteilungen nur noch unwesentlich verändern, daß heißt ab einer Grenze von ca. 10 Werten verändern sich die Wahrscheinlichkeitsverteilungen nur noch marginal.

Wenn nun drei Werte aus einem Wertebereich übertragen werden sollen, so werden diese Werte ihrer Größe nach aufsteigend sortiert, das heißt, daß im Wertebereich die erste Zahl der kleinste Wert ist und die letzte Zahl die größte Zahl. Unter dieser Voraussetzung lassen sich dann die Wahrscheinlichkeitsverteilungen der Figuren 3, 4 und 5 anwenden. Zur Codierung/Decodierung der ersten Zahl wird dann die Wahrscheinlichkeitsverteilung der Figur 5 auf den gesamten Wertebereich angewendet. Nach der Codierung/Decodierung dieser ersten Zahl wird dann die Wahrscheinlichkeitsverteilung der Figur 4 für die Codierung/Decodierung der zweiten Zahl, die ja größer ist als die erste Zahl, verwendet. Dabei wird aber nur noch das Intervall zwischen der kleinsten Zahl und der Obergrenze des Wertebereichs betrachtet. Die Wahrscheinlichkeitsverteilung der Figur 4 wird somit auf dieses Intervall normiert. Durch Intervallschachtelung unter Berücksichtigung der Wahrscheinlichkeitsverteilung der Figur 4 wird dann in diesem Intervall die zweite Zahl codiert/decodiert. Zur Codierung der dritten und größten Zahl wird dann die Wahrscheinlichkeitsverteilung nach der Figur 3 auf das Intervall angewendet, dessen Untergrenze von der zweiten decodierten Zahl und dessen Obergrenze von der Obergrenze des Wertebereichs gebildet wird. Für die Codierung und die Decodierung dieser Zahl wird dann die Wahrscheinlichkeitsverteilung nach der Figur 3 verwendet, die im Ergebnis immer eine Halbierung des Restintervalls bedeutet. Durch diese Vorgehensweise wird die Zahl der für die Codierung der drei Zahlen benötigten Bits gering gehalten.

Da das Verfahren auf Wahrscheinlichkeitsverteilungen beruht, hängt die Zahl der für die Codierung benötigten Bits davon ab, wie sehr die tatsächliche Verteilung der Zahlen diesen Wahrscheinlichkeitsverteilungen entspricht. Es ist daher nicht von vorne herein klar, wieviel Bits für die Codierung eines bestimmten Satzes von Zahlen benötigt werden. Bei einer sehr unwahrscheinlichen Verteilung von Zahlen im Wertebereich kann es im Einzelfall auch einmal auftreten, daß im Vergleich zur einfachen Intervallschachtelung durch Halbierung des Intervalls beim vorliegenden Verfahren mehr Bits benötigt werden. Im statistischen Mittel lassen sich jedoch erhebliche Einsparung in der Größenordnung von um 20% bis 30% verringerten Bitraten erzielen.

Die Figuren 4 und 5 gelten für jeweils zu codierende/decodierende Zahlen, denen größere zu codierende/decodierende Zahlen noch folgen, das heißt für eine aufsteigende Sortierung der zu codierenden/decodierenden Zahlen. Wenn eine absteigende Sortierung der zu codierenden/decodierenden Zahlen verwendet würde, so wäre die Wahrscheinlichkeitsverteilung entsprechend gespiegelt, das heißt die Wahrscheinlichkeit wäre jeweils beim Wert 1 am größten und beim Wert 0 am geringsten.

Die Wahrscheinlichkeitsverteilungen der Figuren 3 bis 5 beruhen auf theoretischen Betrachtungen bezüglich der Verteilung von Werten in einem Werteintervall. Es hat sich jedoch gezeigt, daß auch reale Werte ähnliche Abhängigkeiten zeigen. Als Beispiel sei hier die Übertragung von Audiodaten genannt, die dadurch erfolgt, daß die Frequenzen von Sinusschwingungen als Zahlenwerte übertragen werden. Die Auswertung von realen Audiodaten zeigt dabei, daß die Wahrscheinlichkeit einer bestimmten Frequenz in dem gesamten möglichen Wertebereich der Frequenzen nach einer Sortierung der Frequenzen in aufsteigender oder absteigender Reihenfolge davon abhängt, wieviele weiteren Frequenzen in der Reihe nachfolgen. Diese Wahrscheinlichkeitsverteilungen zeigen ein ähnliches Bild wie die hier betrachteten Wahrscheinlichkeitsverteilungen der Figuren 5 und 6, das heißt bei einer Sortierung der Frequenzen als Reihe von aufsteigenden Zahlen zeigte sich, daß in Abhängigkeit von der Anzahl der weiteren nachfolgenden Frequenzen die Wahrscheinlichkeiten zu kleineren Frequenzwerten hin größer waren als zu großen Frequenzwerten. Durch Auswertung von realen Audiodaten konnten so Musterwahrscheinlichkeiten erstellt werden, die sich in der Praxis für die Codierung von einer aufsteigenden Reihe von Frequenzzahlen, die jeweils die Frequenz von Sinusschwingungen darstellen, die zur Rekonstruktion des ursprünglichen Signals überlagert werden, bewährt haben.

Zur Anwendung dieser gemessenen Wahrscheinlichkeitsverteilungen ist es nicht notwendig die gesamte Wahrscheinlichkeitsverteilung abzuspeichern, sondern es reicht, normiert auf ein Bezugsintervall die sinnvollen Intervallgrenzen für die Intervallschachtelung anzugeben. Im folgenden werden die Intervallgrenzen für die ersten 5 Intervallschachtelungen angegeben, wie sie aus den gewählten Audiodaten gewonnen werden. Es handelt sich dabei jeweils um eine Abfolge von 31 Werte für Intervallgrenzen, die den Wertebereich in 32 Bereiche gleicher Wahrscheinlichkeit unterteilt. Die genannten Werte sind auf einen Wertebereich von 1024 bezogen, das heißt für die Anwendung auf einen konkreten Wertebereich müssen diese Zahlen durch 1024 geteilt werden und dann jeweils mit der Anzahl der Werte im betrachteten Intervall der konkreten Anwendung multipliziert werden. Die Aufteilungsgrenzen durch die die Wahrscheinlichkeitsverteilung in 32 Bereiche gleicher Wahrscheinlichkeit unterteilt wird betragen:
für keinen nachfolgenden Wert:
   53, 87, 118, 150, 181, 212, 243, 275, 306, 337, 368, 399, 431, 462, 493, 524, 555, 587, 618, 649, 680, 711, 743, 774, 805, 836, 867, 899, 930, 961, 992.
Für einen nachfolgenden Wert:
   34, 53, 71, 89, 106, 123, 141, 159, 177, 195, 214, 234, 254, 274, 296, 317, 340, 363, 387, 412, 438, 465, 494, 524, 556, 591, 629, 670, 718, 774, 847.
Für zwei nachfolgende Werte:
   26, 41, 54, 66, 78, 91, 103, 116, 128, 142, 155, 169, 184, 199, 214, 231, 247, 265, 284, 303, 324, 346, 369, 394, 422, 452, 485, 524, 570, 627, 709.
Für drei nachfolgende Werte:
   23, 35, 45, 55, 65, 75, 85, 96, 106, 117, 128, 139, 151, 164, 177, 190, 204, 219, 235, 252, 270, 290, 311, 334, 360, 389, 422, 461, 508, 571, 665.
Für vier nachfolgende Werte:
   20, 30, 39, 48, 56, 64, 73, 81, 90, 99, 108, 118, 127, 138, 149, 160, 172, 185, 198, 213, 228, 245, 263, 284, 306, 332, 362, 398, 444, 507, 608.
Für fünf nachfolgende Werte:
   18, 27, 35, 43, 50, 57, 65, 72, 79, 87, 95, 104, 112, 121, 131, 141, 151, 162, 174, 187, 201, 216, 233, 251, 272, 296, 324, 357, 401, 460, 558.
Für sechs nachfolgende Werte:
   16, 24, 31, 38, 45, 51, 57, 64, 70, 77, 84, 91, 99, 107, 115, 123, 132, 142, 152, 163, 175, 188, 203, 219, 237, 257, 282, 311, 349, 403, 493.
Für sieben nachfolgende Werte:
   12, 19, 25, 30, 35, 41, 46, 51, 56, 62, 67, 73, 79, 85, 92, 99, 106, 114, 122, 132, 142, 153, 165, 179, 195, 213, 236, 264, 301, 355, 452.

Wie bereits oben ausgeführt wurde unterscheidet sich die Wahrscheinlichkeitsverteilung für sehr große Anzahlen von nachfolgenden Werten kaum noch, so daß für diese Fälle immer die Wahrscheinlichkeitsverteilung für sieben nachfolgende Werte verwendet werden kann (zumindest gilt dies für Audiodaten). Weiterhin hat es sich für Audiodaten herausgestellt, daß wenn die ersten fünf Intervallschachtelungen unter Berücksichtigung der Wahrscheinlichkeitsverteilung erfolgen, die zusätzliche Ersparnis bei der weiteren Berücksichtigung der Wahrscheinlichkeitsverteilungen gering ist. Für Audiodaten hat es sich daher als ausreichend herausgestellt, wenn nur die ersten fünf Intervallschachtelungen unter Berücksichtigung der Wahrscheinlichkeitsverteilung erfolgen und evtl. noch verbliebene weitere Intervallschachtelungen einfach mittels einer Teilung des Restintervalls in zwei gleich große neue Teilintervalle erfolgen.

Die Anwendung der Tabellen sei nun anhand der Codierung der Zahl 330 unter der Voraussetzung, daß noch eine weitere Zahl folgt, erläutert:

Die Zahl 330 wird dabei aus einem Intervall von 0 bis 1023 ausgewählt. Ein Blick in die Tabelle zeigt, daß als erste Teilungsgrenze die Zahl 317 anzusetzen ist. Dies bedeutet, daß die Wahrscheinlichkeit für die zu codierende Zahl unterhalb dieser Grenze genauso groß ist wie oberhalb dieser Grenze. Die hier relevante Zahl 330 liegt oberhalb dieser Grenze, so daß das erste Codebit eine 1 ist. Für das verbliebene Intervall von 318 bis 1023 erfolgt die nächste Aufteilung durch den Wert 524, wie der Tabelle zu entnehmen ist. Das zweite codierte Bit beträgt somit 0. Die nächste Aufteilung erfolgt bei 412 (Codebit = 0), das heißt der codierte Wert ist jetzt auf das Intervall von 318 bis 412 eingegrenzt. Die nächste Aufteilung erfolgt dann bei 363 (Codebit 0), das heißt die zu codierende Zahl ist hier auf das Intervall von 318 bis 363 eingeschränkt. Die nächste Aufteilung (340 aus Tabelle) schränkt den Bereich der zu codierenden Zahl auf dem Bereich von 318 bis 340 ein. Die weitere Codierung erfolgt einfach durch Halbierung des so verbliebenen Restintervalls. Die Aufteilung des Intervalls von 318 bis 340 erfolgt also bei der Grenze 329 = (318+340)/2 und führt zu dem Codebit 1. Das somit verbleibende Intervall von 330 bis 340 wird in weiteren Rekursionsschritten jeweils wieder in der Mitte aufgeteilt, bis das sich dabei ergebende Restintervall nur noch die eine zu codierende Zahl (hier also 330) umfaßt.

Durch die so gespeicherten Tabellen kann mit sehr einfachen Mitteln die Reduzierung der benötigten Bits für die Codierung erzielt werden. Der dabei erforderliche Speicheraufwand ist durch die Abspeicherung nur einzelner Grenzen für die Intervalle gering und sowohl die codierende Station 1 wie auch die decodierende Station 2 müssen keinen großen Aufwand für die Anwendung des Verfahrens zur Verfügung stellen.

Das Verfahren ist hier anhand von Zahlen die aus einem Wertebereich ausgesucht werden, beschrieben. Es ist klar, das statt Zahlen jede Art von geordneten Daten verwendet werden können, die in einer Reihenfolge angeordnet werden können. Derartige Daten lassen sich problemlos dann in entsprechende Zahlen in einem Wertebereich umsetzen, so daß das Verfahren für jede Art von Daten geeignet ist. Weiterhin können auch statt einzelne Zahlen Bereiche angegeben werden, das heiß es können so Zahlenbereiche einfach codiert werden.

Das Verfahren wurde hier immer so lange vorgeführt, bis eine einzelne Zahl sicher erkannt wurde. Es ist auch möglich das Verfahren abzubrechen, wenn das verbliebene Restintervall gering ist und für die jeweilige Anwendung akzeptabel ist. Da dadurch die benötigten Bits für die Codierung weiter verringert werden, kann so auch auf eine sehr einfache Weise eine variable Anpassung der Bitrate erfolgen.

## Patentansprüche

1. Verfahren zur Codierung/Decodierung eines Zielbereichs aus einem Wertebereich,
in einem Codierungs/Decodierungs-Schritt für den Zielbereich wird ein Rekursionsschritt wiederholt bis Codebits für den zu codierenden Zielbereich gefunden sind oder anhand der Codebits der zu decodierende Zielbereich gefunden ist,
bei dem Rekursionsschritt wird ein Intervall des Wertebereichs in dem sich der zu codierende/decodierende Zielbereich befindet in zwei neue Intervalle aufgeteilt, es wird durch ein einzelnes Bit signalisiert in welchem der neuen Intervalle sich der zu codierende/decodierende Zielbereich befindet, und das so signalisierte neue Intervall wird als Intervall für den nächsten Rekursionsschritt verwendet, wobei die Codebits für den zu codierenden Zielbereich gefunden sind oder der zu decodierende Zielbereich gefunden ist, wenn das Intervall eine Mindestgröße unterschreitet, **dadurch gekennzeichnet,**
**daß** bei mindestens einem Rekursionsschritt eine Wahrscheinlichkeitsverteilung für den Zielbereich im Intervall zugrunde gelegt wird und aufgrund der Wahrscheinlichkeitsverteilung die neuen Intervalle gewählt werden.

2. Verfahren nach Anspruch 1, **dadurch gekennzeichnet, daß** als Zielbereich eine einzelne Zahl verwendet wird.

3. Verfahren nach Anspruch 1 oder 2, **dadurch gekennzeichnet, daß** die Intervalle bei jedem Rekursionsschritt so gewählt werden, daß der zu codierende/decodierende Zielbereich mit gleich großer Wahrscheinlichkeit in jedem der beiden neuen Intervalle liegt.

4. Verfahren nach einem der vorhergehenden Ansprüche, **dadurch gekennzeichnet,daß** mehrere Zielbereiche zu codieren/decodieren sind, daß die Anzahl der Zielbereiche durch eine Werteanzahl gegeben ist und daß der Codierungs/Decodierungs-Schritt wiederholt wird, bis alle Zielbereiche der Werteanzahl codiert/decodiert sind.

5. Verfahren nach Anspruch 4, **dadurch gekennzeichnet, daß** für die Ermittlung der Wahrscheinlichkeitsverteilung eine Reihenfolge der zu codierenden/decodierenden Zielbereiche festgelegt wird und daß die Wahrscheinlichkeitsverteilung eines Zielbereich davon abhängt wieviel Zielbereiche noch in der Reihenfolge nachfolgen.

6. Verfahren nach Anspruch 5, **dadurch gekennzeichnet, daß** die zu codierenden/decodierenden Zielbereiche eine zunehmende oder absteigende Reihe bilden.

7. Verfahren nach Anspruch 5 oder 6, **dadurch gekennzeichnet, daß** mehrere Wahrscheinlichkeitsverteilungen gespeichert sind, und daß die Auswahl der Wahrscheinlichkeitsverteilungen für einen Codierungs/Decodierungsschritt davon abhängt wieviel Zielbereiche noch in der Reihenfolge nachfolgen.

8. Verfahren nach Anspruch 7, **dadurch gekennzeichnet, daß** die gespeicherten Wahrscheinlichkeitsverteilungen aus Meßwerten von Daten ermittelt wurden.

9. Verfahren nach Anspruch 7, **dadurch gekennzeichnet, daß** die gespeicherten Wahrscheinlichkeitsverteilungen berechnet wurden.

10. Verfahren nach einem der vorhergehenden Ansprüche, **dadurch gekennzeichnet, daß** die zu codierenden/decodierenden Zahlen ganze Zahlen sind.

11. Coder/Decoder zur Codierung/Decodierung eines Zielbereichs aus einem Wertebereich,
in einem Codierungs/Decodierungs-Schritt für den Zielbereich wird ein Rekursionsschritt wiederholt bis Codebits für den zu codierenden Zielbereich gefunden sind oder anhand der Codebits der zu decodierende Zielbereich gefunden ist,
bei dem Rekursionsschritt wird ein Intervall des Wertebereichs in dem sich der zu codierende/decodierende Zielbereich befindet in zwei neue Intervalle aufgeteilt, es wird durch ein einzelnes Bit signalisiert in welchem der neuen Intervalle sich der zu codierende/decodierende Zielbereich befindet, und das so signalisierte neue Intervall wird als Intervall für den nächsten Rekursionsschritt verwendet, wobei die Codebits für den zu codierenden Zielbereich gefunden sind oder der zu decodierende Zielbereich gefunden ist, wenn das Intervall eine Mindestgröße unterschreitet, **dadurch gekennzeichnet,**
**daß** bei mindestens einem Rekursionsschritt eine Wahrscheinlichkeitsverteilung für den Zielbereich im Intervall zugrunde gelegt wird und aufgrund der Wahrscheinlichkeitsverteilung die neuen Intervalle gewählt werden.

## Claims

1. Method for coding/decoding a target range from a value range, wherein
a recursion step is repeated in a coding/decoding step for the target range until code bits are found for the target range to be coded, or the target range to be decoded is found with the aid of the code bits,
an interval of the value range in which the target range to be coded/decoded is located is spilt up in the recursion step into two new intervals, a single bit is used to signal in which of the new intervals the target range to be coded/decoded is located, and the new interval thus signalled is used as interval for the next recursion step, the code bits for the target range to be coded being found, or the target range to be decoded being found, when the interval undershoots a minimum size, **characterized in that** a probability distribution for the target range in the interval is used as a basis in at least one recursion step, and the new intervals are selected on the basis of the probability distribution.

2. Method according to Claim 1, **characterized in that** an individual number is used as the target range.

3. Method according to Claim 1 or 2, **characterized in that** the intervals are selected in each recursion step such that the target range to be coded/decoded lies in each of the two new intervals with equal probability.

4. Method according to one of the preceding claims, **characterized in that** a plurality of target ranges are to be coded/decoded, **in that** the number of the target ranges is given by a number of values, and **in that** the coding/decoding step is repeated until all the target ranges of the number of values are coded/decoded.

5. Method according to Claim 4, **characterized in that** a sequence of the target ranges to be coded/decoded is fixed for the determination of the probability distribution, and **in that** the probability distribution of a target range depends on how many target ranges still follow in the sequence.

6. Method according to Claim 5, **characterized in that** the target ranges to be coded/decoded form an increasing or decreasing series.

7. Method according to Claim 5 or 6, **characterized in that** a plurality of probability distributions are stored, and **in that** the selection of the probability distributions for a coding/decoding step depends on how many target ranges still follow in the sequence.

8. Method according to Claim 7, **characterized in that** the stored probability distributions are determined from measured values of data.

9. Method according to Claim 7, **characterized in that** the stored probability distributions were calculated.

10. Method according to one of the preceding claims, **characterized in that** the numbers to be coded/decoded are whole numbers.

11. Coder/decoder for coding/decoding a target range from a value range,
a recursion step is repeated in a coding/decoding step for the target range until code bits are found for the target range to be coded, or the target range to be decoded is found with the aid of the code bits,
an interval of the value range in which the target range to be coded/decoded is located is spilt up in the recursion step into two new intervals, a single bit is used to signal in which of the new intervals the target range to be coded/decoded is located, and the new interval thus signalled is used as interval for the next recursion step, the code bits for the target range to be coded being found, or the range to be decoded being found, when the interval undershoots a minimum size, **characterized in that** a probability distribution for the target range in the interval is used as a basis in at least one recursion step, and the new intervals are selected on the basis of the probability distribution.

## Revendications

1. Procédé pour le codage/décodage d'un domaine cible contenu dans un domaine de valeurs, selon lequel
dans un pas de codage/décodage pour le domaine cible, un pas de récurrence est répété jusqu'à ce que des bits de code soient trouvés pour le domaine cible à coder ou jusqu'à ce que le domaine cible à décoder soit trouvé au moyen des bits de code,
dans le pas de récurrence, un intervalle du domaine de valeurs dans lequel se trouve le domaine cible à coder/décoder est divisé en deux nouveaux intervalles, on signale par un bit unique celui des nouveaux intervalles dans lequel se trouve le domaine cible à coder/décoder et le nouvel intervalle ainsi signalé est utilisé comme intervalle pour le pas de récurrence suivant, les bits de code pour le domaine cible à coder étant trouvés ou le domaine cible à décoder étant trouvé lorsque l'intervalle devient inférieur à une valeur minimale,
**caractérisé en ce que**
dans au moins un pas de récurrence, une distribution de probabilités pour le domaine cible est prise pour base dans l'intervalle et les nouveaux intervalles sont choisis sur la base de la distribution de probabilités.

2. Procédé selon la revendication 1,
**caractérisé en ce que**
on utilise comme domaine cible un nombre unique.

3. Procédé selon la revendication 1 ou 2,
**caractérisé en ce que**
à chaque pas de récurrence, les intervalles sont choisis de telle manière que le domaine cible à coder/décoder se trouve avec la même probabilité dans chacun des deux nouveaux intervalles.

4. Procédé selon une des revendications précédentes,
**caractérisé en ce que**
plusieurs régions cibles sont à coder/décoder, le nombre des domaines cibles est donné par un nombre de valeurs, et le pas de codage/décodage est répété jusqu'à ce que tous les domaines cibles du nombre de valeurs soient codés/décodés.

5. Procédé selon la revendication 4,
**caractérisé en ce que**
pour déterminer la distribution de probabilités, on fixe un ordre de succession des domaines cibles à coder/décoder, et la distribution de probabilités d'un domaine cible dépend du nombre de domaines cibles qui suivent encore dans l'ordre de succession.

6. Procédé selon la revendication 5,
**caractérisé en ce que**
les domaines cibles à coder/décoder forment une série croissante ou décroissante.

7. Procédé selon la revendication 5 ou 6,
**caractérisé en ce que**
plusieurs distributions de probabilités sont mémorisées et la sélection des distributions de probabilités pour un pas de codage/décodage dépend de la quantité de domaines cibles qui suivent encore dans l'ordre de succession.

8. Procédé selon la revendication 7,
**caractérisé en ce que**
les distributions de probabilités mémorisées ont été obtenues à partir de valeurs de mesures de données.

9. Procédé selon la revendication 7,
**caractérisé en ce que**
les distributions de probabilités mémorisées sont calculées.

10. Procédé selon une des revendications précédentes,
**caractérisé en ce que**
les nombres à coder/décoder sont des nombres entiers.

11. Codeur/décodeur pour le codage/décodage d'un domaine cible contenu dans un domaine de valeurs, dans lequel
dans un pas de codage/décodage pour le domaine cible, un pas de récurrence est répété jusqu'à ce que des bits de code soient trouvés pour le domaine cible à coder ou jusqu'à ce que le domaine cible à décoder soit trouvé au moyen des bits de code,
dans le pas de récurrence, un intervalle du domaine de valeurs dans lequel se trouve le domaine cible à coder/décoder est divisé en deux nouveaux intervalles, on signale par un bit unique celui des nouveaux intervalles dans lequel se trouve le domaine cible à coder/décoder et le nouvel intervalle ainsi signalé est utilisé comme intervalle pour le pas de récurrence suivant, les bits de code pour le domaine cible à coder étant trouvés ou le domaine cible à décoder étant trouvé lorsque l'intervalle devient inférieur à une valeur minimale,
**caractérisé en ce que**
dans au moins un pas de récurrence, une distribution de probabilités pour le domaine cible est prise pour base dans l'intervalle et les nouveaux intervalles sont choisis sur la base de la distribution de probabilités.
